(19) Europäisches Patentamt

European Patent Office

Office européen des brevets

(11) **EP 2 178 213 A1**

(12) **EUROPEAN PATENT APPLICATION**

(43) Date of publication:
   **21.04.2010 Bulletin 2010/16**

(51) Int Cl.:
   *H03M 13/00* *(2006.01)*

(21) Application number: **08305688.7**

(22) Date of filing: **16.10.2008**

(84) Designated Contracting States:
   **AT BE BG CH CY CZ DE DK EE ES FI FR GB GR HR HU IE IS IT LI LT LU LV MC MT NL NO PL PT RO SE SI SK TR**
   Designated Extension States:
   **AL BA MK RS**

(71) Applicant: **Thomson Licensing**
   **92443 Issy-les-Moulineaux Cedex (FR)**

(72) Inventors:
   • **Theis, Oliver**
     **30655 HANNOVER (DE)**

   • **Chen, Xiao-Ming**
     **30165 Hannover (DE)**
   • **Timmermann, Friedrich**
     **30823 GARBSEN (DE)**
   • **Georgi, Marco**
     **30855 Langenhagen (DE)**

(74) Representative: **Thies, Stephan**
   **Deutsche Thomson OHG**
   **European Patent Operations**
   **Karl-Wiechert-Allee 74**
   **30625 Hannover (DE)**

(54) **Methods and apparatuses for error correction coding**

(57)   The invention describes a code generation method, an encoding method, an encoding apparatus, and extended versions thereof. The code generation method comprises removing columns and rows from submatrices of a given matrix, and attaching a small number of additional columns thereto. The encoding method derives a codeword v in 3 parts, one of which is the given information vector u. The remaining 2 parts of the codeword are derived in a recursive, but parallelizable way. The extended versions use the generated code in a context of parallel concatenated LDPC coding.

Figure 2

## EP 2 178 213 A1

### Description

<u>Field of the invention</u>

The invention relates to the field of error correction codes (ECC) for optical storage systems. It may also be applied to magnetic recording storage devices, Redundant Arrays Of Independent Disks or RAID, and transmission systems.

<u>Background of the invention</u>

A class of error correcting codes known as Low Density Parity Check Codes, or LDPC codes, has been adopted for a wide range of applications during past years due to the fact that LDPC Codes show excellent random error correcting behavior when used in conjunction with iterative soft decoding message passing algorithms.

So called quasi-cyclic LDPC codes have proven to be highly suitable for hardware decoder implementation because of their well structured parity check matrix. These codes were originally disclosed 1977 by R.J.G Smith in "Easily Decodable Efficient Selforthogonal block Codes". Smith defined a set of parity check equations on an array of $p \cdot p$ information bits resulting in a code having $k = p^2$ information bits and $(d\text{-}1)p$ parity bits and thereby having a codewordlength $k = p^2 + (d\text{-}1)p$.

[1] RJG Smith: "Easily decodable efficient self-orthogonal block codes", Electronics Letters, Vol 13, # 7, pp. 173-174; 1977.
[2] L Ping, WK Leung, N Phamdo: "Low density parity check codes with semi-random parity check matrix", Electronics Letters, Vol 35, # 1, pp. 38-39; 1999.
[3] Hongwei Song, BVK Vijaya Kumar: "Low-Density Parity-Check Codes for Partial Response Channels", IEEE Signal Processing Magazine, pp. 56-66; 2004.

The invention describes a code generation method, an encoding method, an encoding apparatus, and extended versions thereof.

The code generation method:

■ starts with a Permutation-matrix-based quasi-cyclic LDPC code matrix, which is a block matrix consisting of submatrices that are either identity matrices or circular shift matrices.
■ From these submatrices, certain columns and rows are removed.
■ A small number of additional columns is attached or inserted to the matrix, e.g. by attaching a so-called z matrix,
■ The result is a new parity check matrix Hmz, which has certain desirable properties:

○ The matrix continues to be quasi-cyclic, so that it can be used in the known way for low-compexity encoding, a generator matrix is not needed.
○ All column weights are 2, so that performance degradation is avoided.
○ Within each submatrix of the lower half of H, row weights are 0 in regular intervals. This allows for the encoding process to be parallelized, which in turn allows for bigger data throughput.

■ The resulting code is also denoted as "zArray code", hereinafter.

**More specifically, a low density parity check LDPC code** described by its parity check matrix H is generated according to the invention by the following steps:

- A first intermediate matrix H1 is generated so as to comprise two rows of square, identically sized, binary sub-matrices, where the first row comprises p identity matrices I of size $p \cdot p$, and the second row comprises p increasing powers $S^u$ of a cyclic shift matrix S of size $p \cdot p$, wherein u=0,...,p-1. Note that $S^0$=I.
- From the first intermediate matrix H1, a second intermediate matrix H2 is generated by removing m equidistant columns from each of the sub-matrices of the first intermediate matrix H1 at column indices (r+i·(2r+1)+q) modulo p, wherein i, m, p, q are integers, i=0,...,m-1, m,p,q,r are predefined such that p=m+2mr, and column indices within the sub-matrices start with 0.
- From the second intermediate matrix H2, a third intermediate matrix H3 is generated by deleting those matrix rows from the first row of sub-matrices of the second intermediate matrix H2 which, due to the removing step, contain only zeros, so that the first row of the third intermediate matrix H3 comprises p small identity matrices Is of size (p-m)·(p-m).

2

- From the third intermediate matrix H3, the parity check matrix H of the LDPC code is generated by inserting or appending m-1 binary column vectors of height 2p-m having weight 2, wherein the column vectors have "1" elements in the middle rows of the row ranges of the sub-matrices $[S^0S^1]$ that have row weight 2.

The encoding method:

■ is based on the known requirement that $v \cdot H^T = 0$, i.e. that the codeword v to be generated, when GF2-multiplied with the parity check matrix H, must result in a zero vector.

■ Conceptually, the codeword v is split into 3 parts, one of which is the given information vector u.

■ Steps are described, how the remaining 2 parts of the codeword v can be derived in a recursive, but parallelizable way.

More specifically, according to the invention, encoding an information word u into a code word v with a low density parity check LDPC code as generated according to the invention, the code word v consisting of a first parity part vpar1, a second parity part vpar2, and the information word u, **comprises the steps:**

a) obtaining a first temporary vector w by GF2-multiplying the information word u with an information matrix Hinf;
b) determining the second parity part vpar2 such that its GF2-product with a second parity matrix Hpar2 equals the first temporary vector w except at the (p-m + ((i·(2r+1)+q) mod p))-th vector elements;
c) determining a second temporary vector w2 as the GF2 addition of the GF2-product of the second parity part vpar2 with the second parity matrix Hpar2 and the first temporary vector w;
d) determining the first parity part vpar1 such that its GF2-product with a first parity matrix Hpar1 equals the second temporary vector w2;

wherein the information matrix Hinf comprises those (p-2)·(p-m) columns of the parity check matrix H of the LDPC code that are associated with the information word u, the first parity matrix Hpar1 comprises the inserted or appended binary column vectors, and the second parity matrix Hpar2 comprises the remaining columns of the parity check matrix H.

The encoding apparatus:

■ consists of basic building blocks like permutation, interleaving, matrix multiplication in GF2, mux and demux.
■ The calculation of the middle part of the codewords is done in a number of parallel branches of hardware.
■ The number of parallel branches of hardware is choosable by changing some basic code parameters.

Advantages:

■ By providing column regular codes, the invention avoids performance degrading drawbacks of prior art while maintaining encoding time that grows linearly with codeword length.
■ The invention allows parity bit generation to be split into an adjustable number of independent sequential tasks, enabling parallelization of the encoding process.

The general idea of the invention is applicable to transmission or storage systems in contexts where bit error rate requirements are such that random error correction through iterative soft decision decoding must be used.

**Extensions:**

ZArray codes have column weight j=2 per definition, allowing efficient encodability. On the other hand, low column weight LDPC codes are prone to undetected block (codeword) errors and do not show outstanding Bit Error Rate, or BER, performance over binary additive white Gaussian noise, or AWGN, channels.
It may be considered, that BERs of zArray codes are in the range of other Array codes having similar code rate and codeword length. On Partial Response, or PR, channels, especially on those subjected to Run Length-Limited, or RLL, modulation like storage channels, BER performance of zArray codes can be improved by the use of turbo detection methods using a joint PR-detector and RLL demodulator.
It may also be considered, that zArray Codes perform weak on AWGN channels in comparison to other regular high rate codes such as randomly constructed Gallager codes ("Evaluation of Gallager Codes for Short Block Length and High Rate Applications", David J.C. MacKay, Matthew C. Davey, 1999) [1]. MacKay's codes have been chosen for reference since their parity-check matrices are publicly available at "http://www.inference.phy.cam.ac.uk/mackay/codes/data.html" which allows easy benchmarking.

The performance of zArray codes compared to MacKay's codes mainly has two origins, both due to the way the zArray code's parity check matrix is constructed:

■ low column weight 2
■ short codeword length

Depending on the context, these properties of zArray codes might also be considered as advantages.

In an advantageous **extension**, this invention realizes, that both "shortcomings" of zArray codes mentioned above can be overcome in a way that preserves zArray code advantages, while substantially decreasing BERs.

This extension can be seen under 3 different viewpoints of increasing level of abstraction:

**Viewpoint 1.)** The solution to the zArray codes design "shortcomings" in order to decrease BERs is to concatenate two zArray codes in parallel where the second code's information word is interleaved.The interleaver plays the critical role in this scheme since it affects the BER performance significantly. A constraint for the interleaver design will be given.

**Viewpoint 2.)** Alternatively to interleaving the information word, the columns of the second zArray code parity check matrix corresponding to the information word can be deinterleaved, resulting in a coding scheme of two different parallel "zArray" codes.

**Viewpoint 3.)** The two different parity check matrices can be combined into a single parity check matrix resulting in a new irregular class of zArray codes, named Parallel Concatenated ZArray, or pczArray, codes in the following. The resulting parity check matrices have column weight 4 on information bits and column weight 2 on parity bits. Advantageously, for a given coderate, pczArray codes have codewordlength substantially larger than zArray codes.

More specifically, according to this invention, an information word u is parallel concatenated LDPC encoded into a codeword vpc by

- applying to the information word u the low density parity check LDPC code as generated by the code generation method described herein, thereby generating first parity bits vp1;
- applying to the information word u an interleaver P(u) and then the low density parity check LDPC code as generated by the code generation method described herein, thereby generating second parity bits vp2;
- deriving the codeword vpc by concatenating the information word u, the first parity bits vp1, and the second parity bits vp2.

Advantages of pczArray codes:

1. Improved BER performance compared to zArray codes
2. Improved BLER performance compared to zArray codes
3. Reduced probability of undetected block errors compared to zArray codes
4. Efficient zArray code's encoder and decoder can be used for pczArray codes

Drawings

Exemplary embodiments of the invention are illustrated in the drawings and are explained in more detail in the following description.

In the figures:

**Figure 1** shows a Parity Check Matrix Hmz of a quasi-cyclic LDPC Code with $m$=3 and r=1 p-m=6. Ones are represented by black squares. White and grey squares represent Zeros.

**Figure 2** shows a Parity Check Matrix [Hpar1 Hpar2] of a quasi-cyclic LDPC Code with $m=4, r=1.$ Ones are represented by black squares. White and grey squares represent Zeros.

**Figure 3** shows a block diagram for a 2m-parallel implementation of the vpar2 encoder and for a sequential implementation of the vpar1 encoder.

**Figure 6** shows a Parallel Concatenated zArray LDPC encoder with interleaver and identical encoders.

**Figure 7**    shows an Informationword block interleaver with depth p-2-s.
**Figure 8**    shows an Informationword block interleaver with depth p-m.
**Figure 9**    shows a Parallel Concatenated zArray LDPC decoder with interleaver and identical decoders.
**Figure 10**   shows a Parallel Concatenated zArray LDPC encoder with two different encoders.
**Figure 11**   shows a zArray2 LDPC parity check matrix with parameter m=3, r=1 and s=2, which substitutes information word block interleaving with depth p-2-s.
**Figure 12**   shows a zArray2 LDPC parity check matrix Hpc with parameter m=3, r=1 and s=2, which substitutes information word block interleaving with depth p-m.
**Figure 13**   shows a Parallel Concatenated zArray LDPC decoder with two different decoders.
**Figure 14**   shows a pczArray LDPC parity check matrix Hpc with parameter m=3, r=1 and s=2, which substitutes information word block interleaving with depth p-m.

For a given minimum distance d and maximum column weight $j=d-1$, Smith's code construction results in a parity check matrix Hsmith consisting of px p identity matrices and shift matrices S obtained from the identity matrix through cyclically left-shifting or right-shifting by one position, where p is usually selected to be a prime number.

$$S = \begin{bmatrix} & & & & 1 \\ 1 & & & & \\ & 1 & & & \\ & & \ddots & & \\ & & & 1 & \end{bmatrix}_{p\times p} \quad \text{or} \quad S = \begin{bmatrix} 1 & & & & \\ & 1 & & & \\ & & 1 & & \\ & & & 1 & \\ 1 & & & & \end{bmatrix}_{p\times p}$$

Smith did not employ a parity check matrix notation. Instead he gave algebraic equations to define the parity checks, which translate into the use of right-shifts S in the parity check matrix notation. His construction method can be written as parity check matrix

$$\mathbf{H}smith = \begin{bmatrix} \mathbf{I} & & & \mathbf{I} & \mathbf{I} & \mathbf{I} & \mathbf{I} & \cdots & \mathbf{I} \\ & \mathbf{I} & & \mathbf{I} & S & S^2 & S^3 & \cdots & S^{p-1} \\ & & \mathbf{I} & \mathbf{I} & S^2 & S^4 & S^6 & \cdots & S^{2(p-1)} \\ & & & \ddots & \vdots & \vdots & \vdots & \vdots & \cdots & \vdots \\ & & & \mathbf{I} & \mathbf{I} & S^{j-1} & S^{2(j-1)} & S^{3(j-1)} & \cdots & S^{(j-1)(p-1)} \end{bmatrix}_{jp\times p^2 + jp}.$$

Hsmith defines a quasi-cyclic LDPC code from which the identity matrix is usually removed. The parity check matrix **H** is then given as a $j$ x $p$ block matrix of $p$ x $p$ circulant submatrices.

$$\mathbf{H} = \begin{bmatrix} \mathbf{I} & \mathbf{I} & \mathbf{I} & \mathbf{I} & \cdots & \mathbf{I} \\ \mathbf{I} & S & S^2 & S^3 & \cdots & S^{(p-1)} \\ \mathbf{I} & S^2 & S^4 & S^6 & \cdots & S^{2(p-1)} \\ \vdots & \vdots & \vdots & \vdots & \cdots & \vdots \\ \mathbf{I} & S^{(j-1)} & S^{2(j-1)} & S^{3(j-1)} & \cdots & S^{(j-1)(p-1)} \end{bmatrix}_{jp\times p^2}$$

H specifies a regular (n, k) block code with codeword length n given by $n=p^2$, information word length $k=n$-rank (H) and $n$-$k$ parity bits corresponding to $n$-$k$ parity check equations. The code rate is defined to be the ratio of informationwordlength to codewordlength $R=k/n$.

Since the number of ones within H is small compared to the number of Zeros, the matrix is said to have low density. Each codeword v must satisfy all $n$-$k$ parity checks. This is equivalent to requiring that the vector matrix multiplication of v and H within the Galois field GF2 must yield an all zero vector:

$$\mathbf{v}\mathbf{H}^T = \mathbf{0}\,.$$

Encoding usually requires the existence of a generator matrix G which can be derived from H through Gaussian elimination. GF2-multiplication of the generator matrix with the informationword u requires $O(n^2)$ computations and results in the codeword v=uG.

A straightforward implementation of this encoding is of complexity $O(n^2)$. This complexity might be prohibitive for large codewordlength, so that a modification of the above code has been disclosed in US 2003/0037298**.** There it is shown how a generator matrix $\mathbf{H}_U^S$ is derived from **H** through shifting and triangularization.

$$\mathbf{H}_U^S = \begin{bmatrix} \mathbf{I} & \mathbf{I} & \mathbf{I} & \cdots & \mathbf{I} & \mathbf{I} & \cdots & \mathbf{I} \\ \mathbf{0} & \mathbf{I} & S & \cdots & S^{(j-2)} & S^{(j-2)} & & S^{(p-2)} \\ \mathbf{0} & \mathbf{0} & \mathbf{I} & \cdots & S^{2(j-3)} & S^{2(j-2)} & & S^{2(p-3)} \\ \vdots & \vdots & \vdots & \ddots & \vdots & \vdots & \vdots & \vdots \\ \mathbf{0} & \mathbf{0} & \mathbf{0} & \mathbf{0} & \mathbf{I} & S^{(j-1)} & \cdots & S^{(j-1)(p-1)} \end{bmatrix}$$

This form of the parity check matrix enables linear time encoding. Another solution to the encoding problem can be the use of a "zigzag" matrix $\mathbf{H}_{zz}$ instead of triagularization. This method is generic and can be applied to virtually any existing LDPC code $\mathbf{H}_{any}$ to simplify encoding by defining $\mathbf{H}_{PLP}=[\mathbf{H}_{zz}\ \mathbf{H}_{any}]$ where $\mathbf{H}_{zz}$ is defined as

The parity check equation $\mathbf{v}\mathbf{H}^T=\mathbf{0}$ can then be solved iteratively in the way indicated by arrows to generate the parity bit vector vp. Systematic codewords result from concatenation of parity and information bits.

$$\mathbf{v} = \begin{bmatrix} \mathbf{v}_p \mathbf{u} \end{bmatrix}$$

This method has been disclosed by Ping, Leung and Phamdo in "Low density parity check codes with semirandom parity check matrix".

Zigzag methods can be seen to have the following Disadvantages:

1. Parity bits have to be generated sequentially. This avoids parallelization of the encoding algorithm.
2. The code is not column regular any more (the number of ones per column varies) and there is at least one column having weight 1. This usually degrades soft decision decoding performance.

Disadvantages of the IBM method

1. The code is not column regular any more. $p$ columns have row weight one. This usually degrades soft decision decoding performance.

This invention overcomes the disadvantages of quasi-cyclic LDPC code encoding as stated above while maintaining linear encoding time. For this aim, a new class of LDPC codes is disclosed that allows parity bit generation to be split into an adjustable number of independent sequential tasks enabling parallelization of the encoding process; and is column regular. Additionally, same as the two methods mentioned above, the new class of LDPC codes according to this invention needs no computation of a generator matrix for encoding.

The invention presents a new class of LDPC codes represented by the parity-check matrix Hmz. It can be deduced from H in a way that simplifies encoding (linear time & parallelization) while maintaining the structure of the original parity-check matrix H to keep decoder design simple and efficient especially when message passing algorithms are applied.

The method of this invention is restricted to permutation matrix based quasi-cyclic LDPC codes of type $j=2$.

**Code Construction**

This part describes step by step how a new class of LDPC codes is constructed from the known class of quasi-cyclic LDPC codes as shown above having parameter $j=2$, so that the parity-check matrix is of the form

$$\mathbf{H} = \begin{bmatrix} \mathbf{I} & \mathbf{I} & \mathbf{I} & \mathbf{I} & \cdots & \mathbf{I} \\ \mathbf{I} & S & S^2 & S^3 & \cdots & S^{p-1} \end{bmatrix}_{2p \times p^2}.$$

**Step 1:** Define $p=m+2mr$ with $m,r \geq 1$. This will allow removal of $m$ equidistant rows in the next step.

**Step 2:** Remove m equidistant columns from each submatrix **I** and $S^u$ at column indices (starting at 1) $x=r+i(2r+1)$ +1 with $i=0,..,m$-1. Cyclic shifts of $x$ might also be used for column removal. For the identity matrix **I** this results in

$$\mathbf{I'} = \begin{bmatrix} \ddots & & & & \\ & 1 & & & \\ \cdots & 0 & 0 & \cdots & \\ & 1 & & & \\ & & \ddots & & \end{bmatrix}_{p \times (p-1)}$$

for $m=1$, $r \geq 1$

$$\text{or } \mathbf{I'} = \begin{bmatrix} \ddots & & & & & & & \\ & 1 & & & & & & \\ \cdots & 0 & 0 & \cdots & & & & \\ & 1 & & & & & & \\ & & \ddots & & & & & \\ & & & \ddots & & & & \\ & & & & \ddots & & & \\ & & & & & 1 & & \\ & & & & \cdots & 0 & 0 & \cdots \\ & & & & & 1 & & \\ & & & & & & \ddots & \end{bmatrix}_{p \times (p-m)}$$

for $m > 1$.

For the upper half of the parity check matrix $m$, zero rows can be removed since they do not define a parity check any more. A second identity matrix

$$\mathbf{I''} = \begin{bmatrix} 1 & & \\ & \ddots & \\ & & 1 \end{bmatrix}_{(p-m) \times (p-m)}$$

is therefore defined.

Removal of $m$ equidistant columns from the shift matrices S and its permutations $S^u$ defines a new matrix

$$S' = \begin{bmatrix} & 1 \\ 1 & \\ 0 & 0 \end{bmatrix}_{p \times (p-1)}$$

for $m = r = 1$

or

$$S' = \begin{bmatrix} & & & 1 \\ 1 & & & \\ & 1 & & \\ & & 0 & \\ & & 1 & \end{bmatrix}_{px(p-1)}$$

for $m$=1 an $r$=2
or

$$S'=\begin{bmatrix} & & & & 1 \\ 1 & & & & \\ 0 & 0 & & & \\ & 1 & & & \\ & & 1 & & \\ & & & 0 & \end{bmatrix}_{px(p-2)}$$

for $m$=2 an $r$=1
or

$$S'=\begin{bmatrix} & & & & & & & & 1 \\ \ddots & & & & & & & & \\ & 1 & & & & & & & \\ \cdots & 0 & 0 & \cdots & & & & & \\ & & 1 & & & & & & \\ & & & \ddots & & & & & \\ & & & & \ddots & & & & \\ & & & & & \ddots & & & \\ & & & & & & 1 & & \\ & & & & & \cdots & 0 & 0 & \cdots \\ & & & & & & 1 & & \\ & & & & & & & \ddots & \end{bmatrix}_{px(p-m)}$$

for $m{\geq}2$ an $r{\geq}2$.

After removing a total of $pm$ columns and m rows from **H**, the new parity check matrix reads

$$\mathbf{H}_m = \begin{bmatrix} \mathbf{I''} & \mathbf{I''} & \mathbf{I''} & \mathbf{I''} & \cdots & \mathbf{I''} \\ \mathbf{I'} & S' & S^{2\prime} & S^{3\prime} & \cdots & S^{p-1\prime} \end{bmatrix}_{(2p-m)\times(p-m)p} .$$

**Step 3:** Expand $\mathbf{H}_m$ by $\boldsymbol{z}$=$m$-1 columns having weight 2. This yields the parity check matrix $\mathbf{H}_{mz}$:

$$\mathbf{H}_{mz} = \begin{bmatrix} \mathbf{0} & \mathbf{I''} & \mathbf{I''} & \mathbf{I''} & \mathbf{I''} & \cdots & \mathbf{I''} \\ \mathbf{Z} & \mathbf{I'} & S' & S^{2\prime} & S^{3\prime} & \cdots & S^{p-1\prime} \end{bmatrix}_{(2p-m)\times((p-m)p+z)} .$$

Within **Z,** ones are set in any combination of two rows having neighboring indices $y_z(i)=(2r+1)i$ with $i=0,..,m-1$, i.e. $y_z(0)\&y_z(1)$, $y_z(1)\&y_z(2)$, ..., $y_z(m-2)\&y_z(m-1)$. If cyclic shifts of $x$ have been used for column removal in step 2, row indices $y_z$ will change accordingly.

This defines a new LDPC code with codewordlength $n=(p-m)p+z$ and informationwordlength $k=(p-2)(p-m)$. The code is free of 4-cycles and has only few 6-cycles.

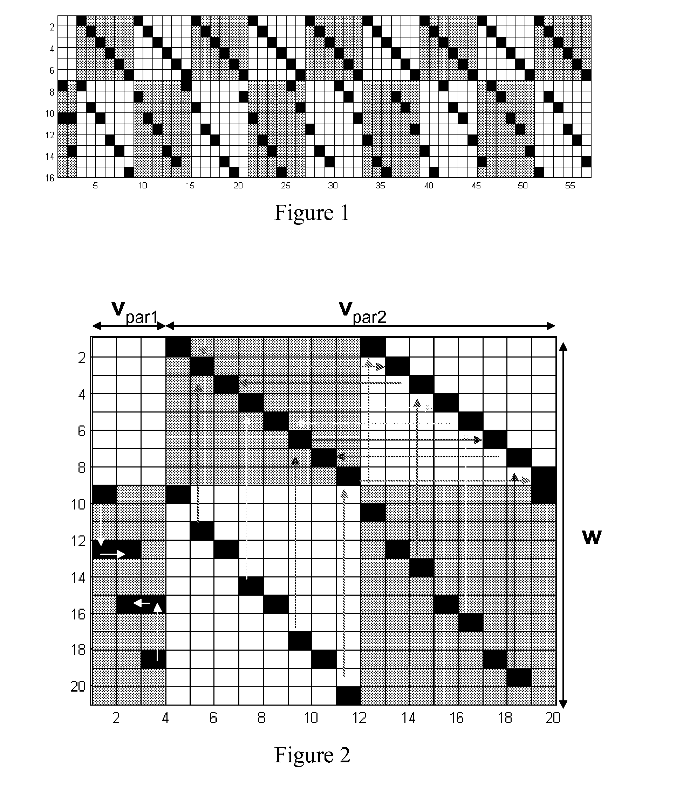

See **Figure 1** for an example of $\mathbf{H}_{mz}$. Figure 1 shows a Parity Check Matrix Hmz of a quasi-cyclic LDPC Code with $m=3$, r=1, and p-m=6. Ones are represented by black squares. White and grey squares represent Zeros.

## Encoding

Given $\mathbf{H}_{mz}$, the parity check equation can be expressed as $\mathbf{vH}_{mz}^{T} = \mathbf{0}$.

If systematic encoding of the codeword $\mathbf{v}=[\mathbf{v}_{par1}\mathbf{v}_{par2}\mathbf{u}]$ is assumed, $\mathbf{H}_{mz}$ splits into two parity parts and one information bit part.

$$\mathbf{H}_{mz} = \begin{bmatrix} \mathbf{H}_z^{par1} & \mathbf{H}_{2(p-m)}^{par2} & \mathbf{H}_{(p-2)(p-m)}^{inf} \end{bmatrix}$$

**Encoding Step 1:** Multiply (in GF2) $\mathbf{u}$ and $\mathbf{H}_{inf}$ to obtain a temporary vector $\mathbf{w} = \mathbf{uH}_{inf}^{T}$.

**Encoding Step 2:** Find vpar2, also denoted as $\mathbf{v}_{par2}$, recursively by solving

$$\mathbf{v}_{par2}\mathbf{H}_{par2}^{T} = \mathbf{w} \qquad (1)$$

in $2m$ independent parallel tasks. Each row of $\mathbf{H}_{par2}$ having weight 1 serves as a starting point for the different recursions, resulting in $2r$ parity bits each.

Alternatively $m$ parallel tasks might be applied each resulting in $4r$ parity bits. Notice that rows having index $y_{mz}(i)$ $=y_z(i)+(p-m)+1$ are not taken into account within the recursions. Equation (1) will therefore likely be violated by these rows since

$$\text{rank}(\mathbf{H}_{par2}) = 4\ r\ m.$$

**Encoding Step 3:** Compute a vector $\mathbf{w'} = \mathbf{v}_{par2}\mathbf{H}_{par2}^{T} \oplus \mathbf{w}$. Actually, only $\mathbf{w}'(y_{mz})$ is needed for the next step.

**Encoding Step 4:** Find vpar1 recursively by solving $\mathbf{v}_{par1}\mathbf{H}_{par1}^{T} = \mathbf{w'}$. This can be done within 2 independent recursive tasks since rank($\mathbf{H}_{par1}$) = z. One task starts with vpar1 (1) = $\mathbf{w}'(y_{mz}$ (0)), and the other task starts with vpar1 ($m$-1) = $\mathbf{w}'(y_{mz}$ ($m$-1)).

**Encoding Step 5:** Assemble $\mathbf{v}= [\mathbf{v}_{par1}\mathbf{v}_{par2}\mathbf{u}]$

**Figure 2** gives an example of how the encoding process is split up into parallel tasks to compute vpar2 first and afterwards vpar1. Figure 2 shows a Parity Check Matrix [$\mathbf{H}_{par1}$ $\mathbf{H}_{par2}$] of an quasi-cyclic LDPC Code with $m=4,r=1$. Ones are represented by black squares. White and grey squares represent Zeros.

## Encoding apparatus

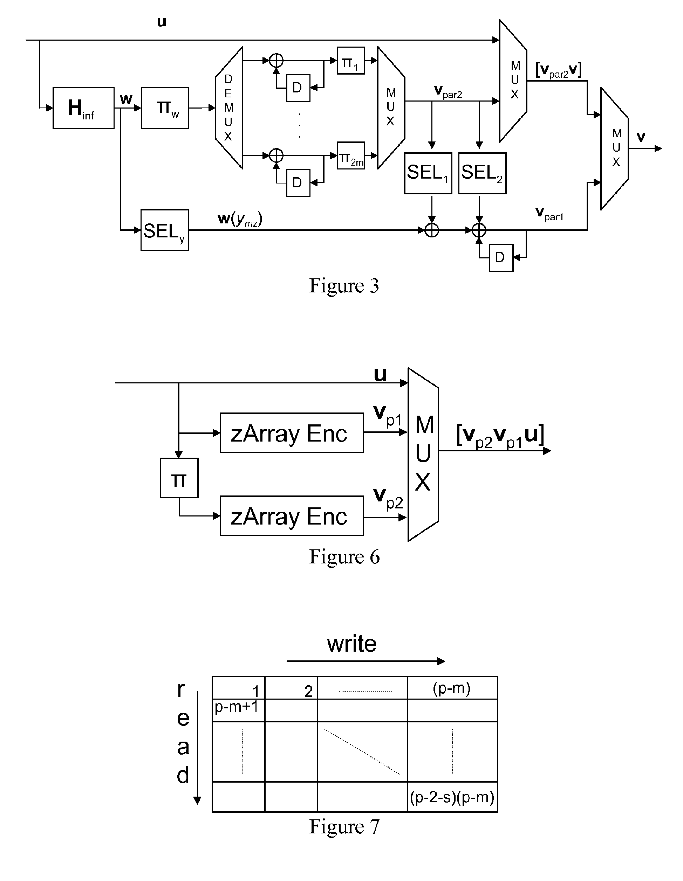

**Figure 3** shows a block diagram for a $2m$-parallel implementation of the vpar2 encoder and for a sequential implementation of the vpar1 encoder.

A hardware realization for the algorithm described above can be directly deduced from the block diagram shown in Figure 3. The vector **w** is generated through the block Hinf which performs matrix vector multiplication with u in GF2. After interleaving **w** through block Pw alöso denoted as $\Pi_w$, a demultiplexer feeds the 2*m* (or *m*) XORs. Again, vpar2 results from interleaving and concatenation. vpar1(*i*) is recursively computed by XORing **w**($y_{mz}$) with vpar2(2*ri*+1) (bit positions selected by SEL$_1$), vpar2(mod(2*ri*-1,*p-m*)+(*p-m*)+1) (bit positions selected by SEL$_2$) and vpar1(*i-1*). Finally **v** is found through concatenation.

For the case of *m*=1 ($\mathbf{H}_m = \mathbf{H}_{mz}$), there exists a very similar class of array codes invented by Mario Blaum (IBM) and published in "A CODING TECHNIQUE FOR RECOVERY AGAINST DOUBLE DISK FAILURE IN DISK ARRAYS" in 1992. These codes can be derived from the code according to this invention by removing column *x*=p instead of removing column *x*=*r*+1 from any submatrix and by setting p to a prime number.

Furthermore, row 2p-1 has to be removed from $\mathbf{H}_m$ to obtain the parity check matrix

$$\mathbf{H}_{array} = \begin{bmatrix} \mathbf{I}^* & \mathbf{I}^* & \mathbf{I}^* & \mathbf{I}^* & \cdots & \mathbf{I}^* \\ \mathbf{I}^* & S* & S*^2 & S*^3 & \cdots & S*^{p-1} \end{bmatrix}_{2(p-1) \text{ x } (p-1)p}$$

with

$$I^* = \begin{bmatrix} 1 & & & \\ & 1 & & \\ & & \ddots & \\ & & & 1 \end{bmatrix}_{(p-1)x(p-1)}$$

and

$$S^* = \begin{bmatrix} 0 & 0 & 0 & 0 \\ 1 & & & 0 \\ & 1 & & 0 \\ & & 1 & 0 \end{bmatrix}_{(p-1)x(p-1)}.$$

Note that S*$^x$ results from S$^x$ by deletion of column p and row p.

Both codes then result in the same codeword **v** for a given information vector u and can therefore not be distinguished.

Blaum's array codes were originally designed for double symbol erasure or single symbol error correction of blocks having length *p-1*. But they can also be considered as LDPC codes to which message passing algorithms can be applied for random error correction. This was discovered by John Fan in "ARRAY CODES AS LOW-DENSITY PARITY-CHECK CODES".

Note that Blaum's array codes can not take advantage of 2-way parallel encoding due to the missing last parity row.

Permutation-matrix-based quasi-cyclic LDPC codes can be derived from a class of codes introduced in a 1977 paper by RJG Smith [1] through shortening of the parity bits and sacrificing parts of the original information for redundancy instead, see [3]. Because of their regularly structured parity check matrix, they are very efficiently decodable.

Ping, Leung and Phamdo, in their 1999 paper [2], have described a way to modify any given parity check matrix into a form that allows to use it in a low-complexity, iterative way yielding the parity bits to a given information word u. This enables for efficient encoding and circumvents the necessity to calculate a generator matrix.

The method of [2] can be seen to have the following drawbacks:

■ Parity bits have to be generated sequentially, which disallows parallelization.

■ The resulting code is not column regular, i.e. the column weight of the parity check matrix varies. At least one column has weight 1, i.e. one information digit is contained in only one of the parity equations. All this typically degrades soft-decision decoding performance.

US 2003/0037298 has modified Permutation-matrix-based quasi-cyclic LDPC codes in such a way that they are more easily encodable in addition. This method, too, may be seen to have the drawback that the proposed code is not column regular. A number "p" of columns have weight 1, which typically degrades soft-decision decoding performance.

The invention builds on permutation-matrix-based quasi-cyclic LDPC codes having column weight 2.

In the following, it will be described how the zArray codes can be extended by using them in a parallel concatenated coding scheme. This extension can be seen under 3 different viewpoints of increasing level of abstraction:

**Viewpoint 1.)** The solution to the zArray code's design "shortcomings" in order to decrease BERs is to concatenate two zArray codes in parallel where the second code's information word is interleaved in a way defined by the invention. The interleaver P also denoted as $\Pi$ plays a critical role in this scheme since it affects the BER performance significantly.

**Figure 6** shows a Parallel Concatenated zArray LDPC encoder with interleaver and identical encoders. The codeword $\mathbf{v}_{pc}=[\mathbf{v}_{p2}\ \mathbf{v}_{p1}\ \mathbf{u}]$ of a pczArray code is derived from the informationword u and its concatenation with parity bits $\mathbf{v}_{p1}$ from a first zArray encoder working on u and with parity bits $\mathbf{v}_{p2}$ from a second identical zArray encoder working on $\Pi(\mathbf{u})$.

With the zArray code variable $p=m+2mr$ depending on the two code parameters m and *r* as defined above, the number of symbols per information word **u** results as $p$-2, where the symbol length is given by $p$-$m$.

In order to obtain low block error rates or BLERs and low bit erropr rates or BERs, it is important that the number of symbols within **u** and the symbol length must be relatively prime to each other, i.e. their greatest common devisor (gcd) must equal 1.

$$gcd(p\text{-}2,\ p\text{-}m) \equiv 1 \quad (I)$$

It is often necessary to adjust coderate and blocklength to application needs by information word shortening, i.e. replacing a certain amount of information bits of **u** by zeros which will not be transmitted. Without loss of generality it will be assumed hereinafter, that the number of zeros is a multiple of the symbol length $p$-$m$ and that zeros will be inserted at the end of **u.** For this purpose, a third zArray code parameter *s* is introduced, denoting the number of zero filled symbols. The information wordlength *k* then results as $k=(p\text{-}2\text{-}s)(p\text{-}m)$. With $s>0$, the above condition (I) then becomes:

$$gcd(p\text{-}2\text{-}s,\ p\text{-}m) \equiv 1 \quad\quad\quad (II)$$

It is the intention not to define the interleaver $\Pi$ more specifically for keeping as much design freedom as possible. As one example, a block interleaving scheme having depth $p$-2-$s$ , as shown in **Figure 7,** where bits of **u** are written row-wise top down into a mother matrix of dimension [$p$-2-$s$, $p$-$m$] and are read out column-wise from left to right can be used. Figure 7 shows an Informationword block interleaver with depth p-2-s.

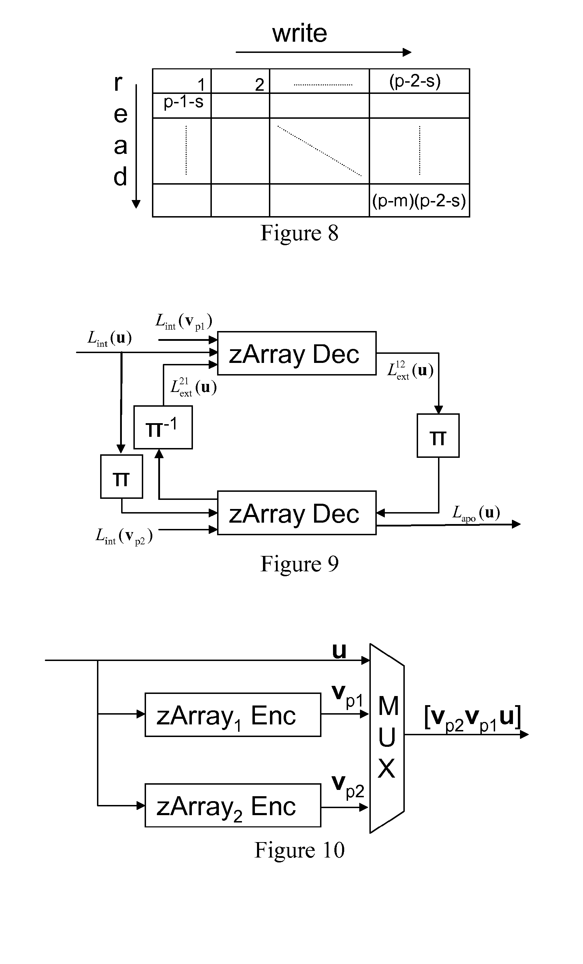

Another example is an interleaver having depth $p$-$m,$ as shown in **Figure 8.** Figure 8 shows an Informationword block interleaver with depth p-m.

Decoding can be done in a turbo decoding scheme, where extrinsic information from one decoder serves as apriori knowledge for the other decoder within several iterations, as shown in **Figure 9.** Figure 9 shows a Parallel Concatenated zArray LDPC decoder with interleaver and identical decoders.

The idea of parallel concatenated codes and turbo decoding was successfully applied to convolutional codes by C. Berrou, A.Glavieux and Punya Thitimayshima who disclosed their landmark paper "Near Shannon limit error-correction coding and decoding: Turbo-codes" in 1993. The corresponding patent US 5,446,747 discloses "systematic convolutional coding" as the constitutent coders, although it is stated that other codes might be used as well.

**Viewpoint 2.)** Instead of interleaving the information word with an interleaver P or $\Pi$, the columns of the second zArray code parity check matrix corresponding to the information word can be deinterleaved with the inverse interleaver $P^{-1}$ or $\Pi^{-1}$, resulting in a coding scheme as shown in **Figure 10,** comprising a conventional zArray encoder zArray1 and a second encoder zArray2. Figure 10 shows a Parallel concatenated zArray LDPC encoder with two different encoders.

Notice that parity check matrix column deinterleaving for the second code basically destroys the quasicyclic block structure of the zArray code. Therefore zArray2 is not a zArray code in the original sense anymore!

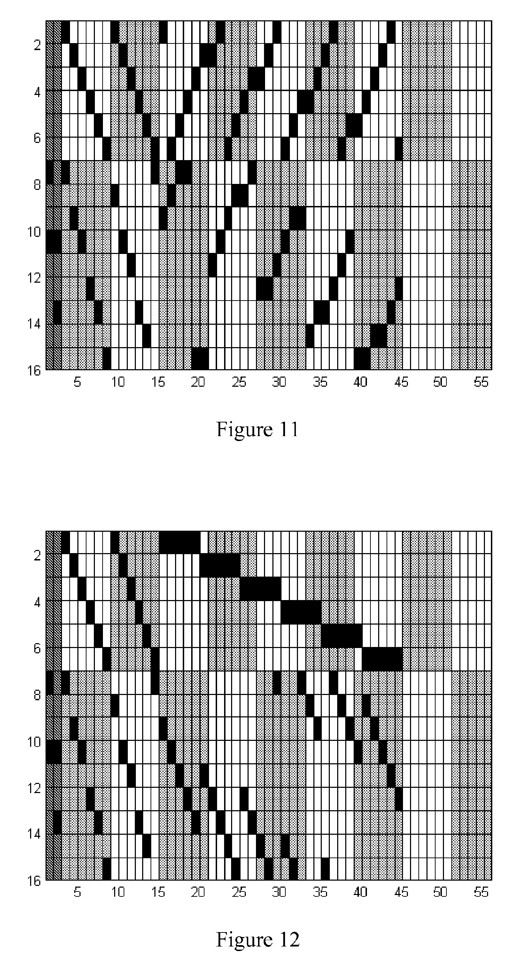

An example for a parity check matrix of zArray2 substituting an information word block interleaver $\Pi$ having depth *p-2-s* (as given by **Figure 7**) is given in **Figure 11.**

Another example for a parity check matrix of zArray2 substituting a information word block interleaver $\Pi$ having depth *p-m* (as given by **Figure 8**) is given in **Figure 12.**

Since parity check bit order has not been changed, the encoding schedule as described above basically stays the same, despite the fact that the non quasi-cyclic code structure makes computation of the temporary vector **w** more difficult.

The scheme of two different parallel concatenated LDPC codes is already known as PCGC (parallel concatenated Gallager Codes) and has been published by H. Behairy and S.-C. Chang in November of 2000 in "Parallel concatenated Gallager Codes". They confirmed and complemented their results in 2002 in "Analysis and design of parallel concatenated Gallager codes". Behairy and Chang propose to use LDPC codes with different mean column weight (MCW).

In contrast, in this invention the second zArray code results from the first zArray code through column (de) interleaving of information word columns, so that both codes have regular column weight 2.

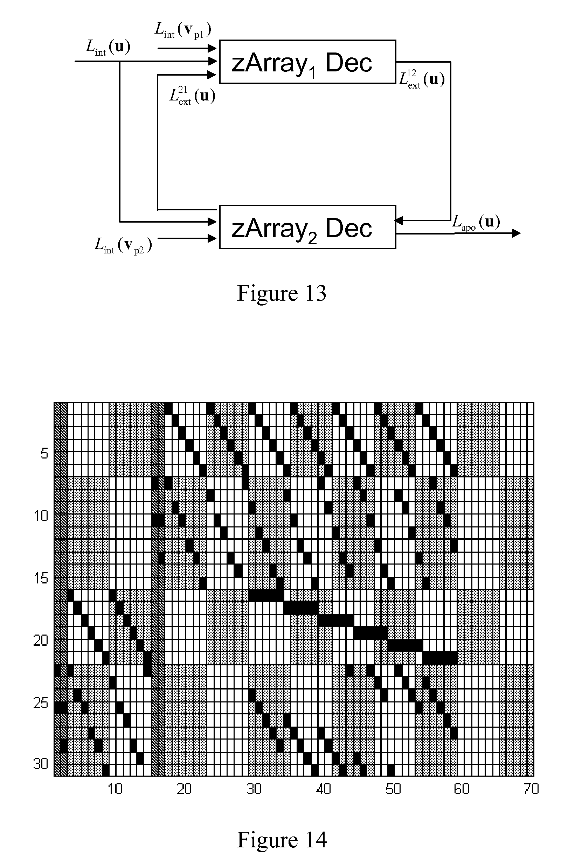

Behairy/Chang also propose to use a LDPC decoder for each code in a turbo decoding way (as it is shown in **Figure 13** for pczArray codes), where extrinsic information from one decoder serves as apriori knowledge for the other. This decoding scheme has the advantage that no interleaver delay occurs during decoding in contrast to the one given in **Figure 9.** Nevertheless high throughput decoding might be difficult due to the non quasi-cyclic code structure of zArray2. **Figure 11** shows a zArray2 LDPC parity check matrix with parameter m=3, r=1 and s=2, substituting information word block interleaving with depth p-2-s. **Figure 12** shows a zArray2 LDPC parity check matrix Hpc with parameter m=3, r=1 and s=2, substituting information word block interleaving with depth p-m. **Figure 13** shows a Parallel concatenated zArray LDPC decoder with two different decoders.

**Viewpoint 3.)** The two different parity check matrices of zArray1 and zArray2 can be combined into a single parity check matrix Hpc, also denoted as $\mathbf{H}_{pc}$, resulting in a **new** irregular class of zArray codes, named Parallel Concatenated ZArray codes or pczArray codes in the following. These codes have column weight 4 on information bits and column weight 2 on parity bits. For a given coderate, pczArray codes have codewordlength substantially larger than zArray codes. **Figure 14** shows the pczArray code parity check matrix corresponding to **Figure 12.**

Since LDPC codes are defined by their parity check matrix alone, the method of parallel code concatenation is hidden in the approach according to the viewpoint 3. The invention can therefore also be seen as a method for LDPC code construction especially for extending the zArray codes construction design space.

**Figure 14** shows a pczArray LDPC parity check matrix Hpc with parameter m=3, r=1 and s=2, substituting information word block interleaving with depth p-m.

Encoding can be done by an implementation given by **Figure 6** or **Figure 10.**

Instead of performing turbo decoding on zArray1 and zArray2, a single pczArray LDPC decoder is used where for example a message passing schedule can be carried out over $\mathbf{H}_{pc}$.

With other words, the invention describes a code generation method, an encoding method, an encoding apparatus, and extended versions thereof. The code generation method comprises removing columns and rows from submatrices of a given matrix, and attaching a small number of additional columns thereto. The encoding method derives a codeword v in 3 parts, one of which is the given information vector u. The remaining 2 parts of the codeword are derived in a recursive, but parallelizable way. The extended versions use the generated code in a context of parallel concatenated LDPC coding.

**Claims**

1. A **method for generating a low density parity check LDPC code** described by its parity check matrix (H), the method comprising the steps of:

   - generating a first intermediate matrix (H1) comprising two rows of square, identically sized, binary sub-matrices, where the first row comprises p identity matrices (I) of size p·p, and the second row comprises p increasing powers ($S^u$) of a cyclic shift matrix (S) of size p·p, wherein u=0,...,p-1;
   - generating from the first intermediate matrix (H1) a second intermediate matrix (H2) by removing m equidistant columns from each of the sub-matrices of the first intermediate matrix (H1) at column indices (r+i·(2r+1)+q) modulo p, wherein i, m, p, q are integers, i=0,...,m-1, m,p,q,r are predefined such that p=m+2mr, and column indices within the sub-matrices start with 0;
- generating from the second intermediate matrix (H2) a third intermediate matrix (H3) by deleting those matrix rows from the first row of sub-matrices of the second intermediate matrix (H2) which, due to the removing step, contain only zeros, so that the first row of the third intermediate matrix (H3) comprises p small identity matrices (Is) of size (p-m)·(p-m);
- generating from the third intermediate matrix (H3) the parity check matrix (H) of the LDPC code by inserting or appending m-1 binary column vectors of height 2p-m having weight 2, wherein the column vectors have "1" elements in the middle rows of the row ranges of the sub-matrices [$S^0S^1$] that have row weight 2.

2. A method according to claim 1, wherein in an i-th one of the column vectors elements are set to "1" at row
p-m + ((i·(2r+1)+q) mod p) and at row
p-m + (((i+1)·(2r+1)+q) mod p), wherein i=0, ...,m-2 and row indices start with 0, and wherein the elements are set to "0" at all other rows.

3. A **method for encoding** an information word (u) into a code word (v) with a low density parity check LDPC code as generated by the method of claim 1, wherein the code word (v) consists of a first parity part (vpar1), a second parity part (vpar2), and the information word (u), the method **comprising the steps:**

   **a)** obtaining a first temporary vector (w) by GF2-multiplying the information word (u) with an information matrix (Hinf);
   **b)** determining the second parity part (vpar2) such that its GF2-product with a second parity matrix (Hpar2) equals the first temporary vector (w) except at the (p-m + ((i·(2r+1)+q) mod p))-th vector elements;
   **c)** determining a second temporary vector (w2) as the GF2 addition of the GF2-product of the second parity part (vpar2) with the second parity matrix (Hpar2) and the first temporary vector (w);
   **d)** determining the first parity part (vpar1) such that its GF2-product with a first parity matrix (Hpar1) equals the second temporary vector (w2);

   wherein the information matrix (Hinf) comprises those (p-2)·(p-m) columns of the parity check matrix (H) of the LDPC code that are associated with the information word (u), the first parity matrix (Hpar1) comprises the inserted or appended binary column vectors, and the second parity matrix (Hpar2) comprises the remaining columns of the parity check matrix (H).

4. A method according to claim 3, wherein the determining of method step b) is performed in 2·m sequences of calculation starting at those 2·m rows of the second parity matrix (Hpar2) that have row weight 1, with each sequence of calculation producing 2·r parity bits.

5. A method according to claim 3, wherein the determining of method step b) is performed in m sequences of calculation starting at m of the 2·m rows of the second parity matrix (Hpar2) that have row weight 1, with each sequence of calculation producing 4·r parity bits.

6. A method according to claim 4 or 5, wherein the sequences of calculation are performed in parallel.

7. A method according to claim 3, wherein the determining of method step d) is performed in 2 sequences of calculation starting at those 2 rows of the first parity matrix (Hpar1) that have row weight 1, with each sequence of calculation producing m-1 parity bits.

8. **Method for parallel concatenated LDPC encoding** an information word (u) into a codeword (vpc), the method comprising the steps of:

   - applying to the information word (u) the low density parity check LDPC code as generated by the method of claim 1, thereby generating first parity bits (vp1);
   - applying to the information word (u) an interleaver (P(u)) and then the low density parity check LDPC code as generated by the method of claim 1, thereby generating second parity bits (vp2);
   - deriving the codeword (vpc) by concatenating the informationword (u), the first parity bits (vp1), and the second parity bits (vp2).

9. Method for parallel concatenated LDPC encoding an information word (u) into a codeword (vpc), the method comprising the steps of:

- applying to the information word (u) the low density parity check LDPC code as generated by the method of claim 1, thereby generating first parity bits (vp1);
- applying to the information word (u) a low density parity check LDPC code that is equivalent to the code as generated by the method of claim 1 after interleaving the columns of the code's parity check matrix, thereby generating second parity bits (vp2);
- deriving the codeword (vpc) by concatenating the informationword (u), the first parity bits (vp1), and the second parity bits (vp2).

10. Method for LDPC encoding information words (u),
**characterized in that** the parity check matrix (H) of the LDPC code is a parallel concatenated parity check matrix (Hpc) comprising a parity check matrix of the LDPC code as generated by the method of claim 1, juxtaposed to a column interleaved parity check matrix of the LDPC code as generated by the method of claim 1.

Figure 1

Figure 2

Figure 3

Figure 6

Figure 7

write →

| | 1 | 2 | .......... | (p-2-s) |
|---|---|---|---|---|
| p-1-s | | | | |
| | | | | |
| | | | | (p-m)(p-2-s) |

read ↓

Figure 8

Figure 9

Figure 10

Figure 11

Figure 12

Figure 13

Figure 14

Europäisches
Patentamt

European
Patent Office

Office européen
des brevets

**DECLARATION**

**Application Number**

which under Rule 63 of the European Patent Convention EP 08 30 5688
shall be considered, for the purposes of subsequent
proceedings, as the European search report

| The Search Division considers that the present application, does not comply with the provisions of the EPC to such an extent that it is not possible to carry out a meaningful search into the state of the art on the basis of all claims | CLASSIFICATION OF THE APPLICATION (IPC) |
|---|---|
| Reason: | INV.<br>H03M13/00 |

Claim 1 defines a method for generating a
matrix which may be used to generate LDPC
codewords. However, matrix construction as
such is a mathematical method as such,
which is excluded from patentability under
Art. 52(2)(a) EPC. Claims 3, 8, 9 and 10
define a type of parallel concatenated
encoding (which is well known as such)
using an "LDPC code as generated by the
method of claim 1", i.e. claims 3 and 8-10
provide indirect definitions. It is not
clear, however, what constraint, if any,
claim 1 should imply on the resulting
H-matrix, and the matrix construction
method of claim 1 is not performed by the
methods of claims 3 and 8-10.  It is
therefore not clear what claims 3 and 8-10
actually define.

The applicant's attention is drawn to the
fact that a search may be carried out
during examination following a declaration
of no search under Rule 63 EPC, should the
problems which led to the declaration
being issued be overcome (see EPC
Guideline C-VI, 8.2).
-----

EPO FORM 1504 (P04F37)

| Place of search | Date | Examiner |
|---|---|---|
| The Hague | 16 February 2009 | Van Staveren, Martin |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20030037298 A

- US 5446747 A

### Non-patent literature cited in the description

- **RJG Smith.** Easily decodable efficient self-orthogonal block codes. *Electronics Letters,* 1977, vol. 13 (7), 173-174
- **L Ping ; WK Leung ; N Phamdo.** Low density parity check codes with semi-random parity check matrix. *Electronics Letters,* 1999, vol. 35 (1), 38-39
- **Hongwei Song ; BVK Vijaya Kumar.** Low-Density Parity-Check Codes for Partial Response Channels. *IEEE Signal Processing Magazine,* 2004, 56-66

- **David J.C. MacKay ; Matthew C. Davey.** *Evaluation of Gallager Codes for Short Block Length and High Rate Applications,* 1999
- *A CODING TECHNIQUE FOR RECOVERY AGAINST DOUBLE DISK FAILURE IN DISK ARRAYS,* 1992